# EUROPÄISCHE PATENTSCHRIFT

(11) **EP 0 922 307 B1**
(45) Veröffentlichungstag und Bekanntmachung des Hinweises auf die Patenterteilung: **09.10.2002**
(21) Anmeldenummer: 97918909.9
(22) Anmeldetag: 27.08.1997
(51) Int. Cl.: H01L 39/12, H01L 39/22, H01L 39/24

(54) **SCHICHTENFOLGE SOWIE EINE SOLCHE ENTHALTENDES BAUELEMENT**
SERIES OF LAYERS AND COMPONENT CONTAINING SUCH
SERIE DE COUCHES ET COMPOSANT RENFERMANT UNE TELLE SERIE

(30) Priorität: 27.08.1996 DE 19634463; 27.08.1996 DE 19634645
(43) Veröffentlichungstag der Anmeldung: 16.06.1999
(73) Patentinhaber: Forschungszentrum Jülich GmbH, 52425 Jülich (DE)
(72) Erfinder: HOJCZYK, Ricardo, D-52066 Aachen (DE); POPPE, Ulrich, D-52349 Düren (DE); JIA, Chunlin, D-52428 Jülich (DE)
(86) Internationale Anmeldenummer: DE9701857
(87) Internationale Veröffentlichungsnummer: WO98009338

(56) Entgegenhaltungen:
- EP-A- 0 533 568

## Beschreibung

Die Erfindung betrifft eine Schichtenfolge gemäß dem Oberbegriff des Anspruchs 1 sowie dessen Verwendung, insbesondere für die Bildung eines kryogenen Bauelements.

Es wird zu der Erfindung gemäß Patentanspruch 1 bis 9 folgendes ausgeführt:

Grundlage für Bauelemente der Supraleitungselektronik ist ein epitaktisches Multilagensystem mit wenigstens einer Schichtenfolge, in welcher das supraleitende Material Grenzflächen zu nicht supraleitenden Materialien bildet. Soll das Bauelement auf ein gewünschtes Substrat aufgewachsen werden, kann gegebenenfalls eine Pufferschicht erforderlich sein.

Als Stand der Technik ist folgendes bekannt:

### 1. Bauelemente der Supraleitungselektronik

Epitaktische Schichtenfolgen bzw. Multilagensysteme für solche Bauelemente bestehen aus einem oder mehreren epitaktischen Dünnfilmen eines hochtemperatursupraleitenden Materials und einem oder mehreren epitaktischen Dünnfilmen aus nichtsupraleitendem Material. Diese nichtsupraleitenden Materialien können dabei zum Beispiel die Funktion einer isolierenden Schicht, eines Barrierenmaterials in Josephson-Kontakten, einer Passivierung oder einer Diffusionssperre ausüben. Aufgrund der Eigenschaften der Hochtemperatursupraleiter werden an diese nichtsupraleitenden Materialien folgende Anforderungen gestellt:

Der Hochtemperatursupraleiter und das nichtsupraleitende Material müssen chemisch kompatibel sein. Dies bedeutet, daß es zu keiner chemischen Reaktion der Materialien kommen darf. Das nichtsupraleitende Material soll sowohl auf dem Hochtemperatursupraleiter als auch der Hochtemperatursupraleiter auf dem nichtsupraleitenden Material epitaktisch wachsen, und zwar in der gewünschten kristallografischen Orientierung. Die so entstehende Grenzfläche soll atomar scharf sein, es sollen sich in ihrer Umgebung keine fehlorientierten Bereiche und Fremphasen bilden. Da aufgrund einer relativ hohen Herstellungstemperatur der Schichten eine Interdiffusion von Ionen nicht ausgeschlossen werden kann, muß gesichert sein, daß die Fremdionen in den Materialien die Eigenschaften dieser möglichst nur geringfügig beeinträchtigen. Es ist beispielsweise bekannt, daß vor allem kleine Ionen wie Al, Ga, Ti, W, Fe, Zn oder auch Ce, Pr die Supraleitfähigkeit des Hochtemperatursupraleiters REBa₂Cu₃O_{7-z} mindern.

Dieses betrifft unter anderem auch den Sauerstoffgehalt und die Ordnung der Sauerstoffatome in den Hochtemperatursupraleitern, bei denen durch Sauerstoffverlust oder Sauerstoffunordnung die Supraleitfähigkeit geschwächt wird. Ein hohes Maß an chemischer Kompatibilität muß gefordert werden, wenn das nichtsupraleitende Material beispielsweise als dünne Barriere in Josephson-Kontakten verwendet werden soll. Aufgrund der geringen Kohärenzlänge der Hochtemperatursupraleiter - typischerweise im Bereich 1 nm bis 2 nm - ist es bezüglich des Barrierenmaterials erforderlich, daß auf einem Längenbereich der Kohärenzlänge der Ordnungsparameter der supraleitenden Elektroden in der Nähe der Grenzfläche, beispielsweise durch Ionendiffusion oder Gitterverzerrung, nicht reduziert wird. Bisher ist kein Material bekannt, welches diese Anforderungen hinreichend erfüllt.

Unterschiedliche thermische Ausdehnungskoeffizienten dürfen auch bei größeren Schichtdicken der Materialien und mehrmaligem Durchlaufen von thermischen Zyklen nicht zu Rißbildung führen.

In Bauelementen aus epitaktischen Multilagen, in welchen die unterschiedlichen Schichten untereinander oder gegenüber dem Substrat unterschiedliche Gitterkonstanten aufweisen, sollen möglichst keine Versetzungen oder starke Verspannungen oder eine sonstige Form einer Gitterfehlordnung in den einzelnen Schichten auftreten, da diese die Funktion des Bauelements negativ beeinflussen können. Die durch die Gitterfehlpassung entstehende Gitterverspannung soll im Idealfall direkt an der Grenzfläche abgebaut werden, so daß die Schichtbereiche in der Umgebung der Grenzfläche möglichst verzerrungsfrei sind.

Die Materialuntersuchungen konzentrieren sich auf zwei Materialklassen. Die eine Klasse orientiert sich an der Struktur von REBa₂Cu₃O_{7-z}. Man versucht durch gezielte Ersetzung und Dotierung einer oder mehrerer Ionensorten die supraleitenden Eigenschaften dieser Verbindung zu reduzieren oder sogar ganz zu unterdrücken.

Die zweite Klasse umfaßt Perovskite bzw. perovskitähnliche Verbindungen. Aus jeder Klasse wird stellvertretend ein Material näher diskutiert werden.

Das nichtsupraleitende Material PrBa₂Cu₃0_{7-z} unterscheidet sich chemisch vom YBa₂Cu₃0_{7-z} nur durch die Ersetzung des Y durch Pr, was den Verlust der Supraleitung bewirkt. Die Gitterfehlpassung mit YBa₂Cu₃O_{7-z} beträgt nur 1%. Im Vergleich zu den meisten anderen bisher untersuchten nichtsupraleitenden Materialien zeigt PrBa2CU307-z den höchsten Grad chemischer und struktureller Kompatibilität mit YBa₂Cu₃0_{7-z}. Beispielsweise hat eine Monolage aus YBa₂Cu₃0_{7-z}, welche sich als Zwischenschicht in einer PrBa2CU307-z Matrix befindet, eine Sprungtemperatur von 30K (T. Terashima et al., Phys. Rev. Lett. 67, 1362 (1991).

Ähnliche Experimente mit anderen nichtsupraleitenden Materialien zeigen, daß dieser Wert von keinem anderen Material bisher erreicht wurde. Wesentliche Nachteile von PrBa2CU307-z sind jedoch zum einen sein relativ geringer spezifischer Widerstand, wodurch es für Isolationszwecke nur bedingt geeignet ist, und zum anderen die durch eine Diffusion des Pr-Ions in das YBa₂Cu₃0_{7-z} hervorgerufene Absenkung des Ordnungsparameters an der Grenzfläche. Ersetzt man beispielsweise lediglich 5% der Y-Atome in YBa₂Cu₃O_{7-z} durch Pr-Atome, wird bereits die Sprungtemperatur von 92K auf 85K reduziert (M.S. Hedge et al., Phys. Rev. B 48, 6465 (1993)).

Ein typischer Vertreter aus der zweiten Klasse der perovskitartigen Verbindungen ist SrTi03. Dieses Material hat eine kubische Kristallstruktur, dessen Gitterfehlpassung zu YBa₂Cu₃O_{7-z}, 1,2% beträgt. Der spezifische Widerstand ist mit 200 MΩcm deutlich größer als für PrBa2CU307-z. Es zeigte sich bei diesem Material, daß eine Heteroepitaxie mit YBa₂Cu₃O_{7-z} möglich ist. Die chemische Kompatibilität des Materials ist allerdings eingeschränkt. Die Diffusion von Ti-Ionen sowie deren Einbau auf die Cu-Plätze von YBa₂Cu₃O_{7-z} führt zu einer Reduktion des Ordnungsparameters in der Nähe der Grenzfläche. Des weiteren reduziert die Gitterverspannung in YBa₂Cu₃O_{7-z}, entstanden durch die Grenzfläche zu SrTiO₃, den Ordnungsparameter in beträchtlicher Weise.

### 2. Pufferschichten

Anwendungsorientierte Anforderungen können es erforderlich machen, die Hochtemperatursupraleiter-Dünnschicht oder das eine solche Schicht enthaltende Bauelement auf ein Substrat wachsen zu lassen, welches z. B. unter dem Aspekt der chemischen Kompatibilität und/oder unter dem Aspekt der Gitterfehlanpassung nicht geeignet ist. Beispiele hierfür sind die Materialien Silizium oder Saphir. Beide reagieren in unerwünschter Weise chemisch mit dem Hochtemperatursupraleiter YBa₂Cu₃O_{7-z}.

Sie haben im Vergleich zu diesen eine große Differenz in den thermischen Ausdehnungskoeffizienten und im Falle des Saphirs eine große Gitterfehlpassung im Bereich von 7-11%, abhängig von der betrachteten kristallografischen Richtung. Um trotzdem eine Epitaxie auf diesen Substraten zu ermöglichen, werden eine oder mehrere sogenannte Pufferschichten eingesetzt, die zwischen Substrat und Dünnschicht/Dünnschichtsystem angeordnet sind. Der Puffer bietet der YBa₂Cu₃O_{7-z} eine glattere und sauberere Oberfläche als das Substrat.

Ferner kann die Schicht als Diffusionssperre wirken. Besonders für dünne supraleitende Schichten ist es entscheidend, daß in der Nähe der Grenzfläche im Supraleiter möglichst keine Gitterverzerrung auftritt. Die Pufferschichten dienen damit dem Zweck, Eigenschaften der supraleitenden Dünnschicht auf einem gegebenen Substrat zu verbessern.

Zur Bildung einer Epitaxie auf diesen Substraten werden eine oder mehrere sogenannte Pufferschichten eingesetzt, die zwischen Substrat und Dünnschicht / Dünnschichtsystem angeordnet sind.

Pufferschichten werden ebenfalls eingesetzt zur Erzielung glatterer Oberflächen der Hochtemperatursupraleiter-Dünnschicht auf bestimmten Substraten. Für SrTiO₃-Pufferschichten ist eine sogenannte ausgleichende Wirkung beobachtet worden. D. h. wird SrTiO₃ auf eine atomare Stufen enthaltende YBa₂Cu₃O_{7-z}-Oberfläche aufgewachsen, überdeckt es diese Oberfläche und bildet nach wenigen nm Dicke eine glatte [100]-Oberfläche. Diese Oberfläche ist sodann zum c-Achsen-orientierten Wachstum des YBa₂Cu₃O_{7-z} geeignet. Eine Pufferschicht dient damit im allgemeinen dem Zweck, bestimmte Eigenschaften der Dünnschicht auf einem gegebenen Substrat zu verbessern.

Die Anforderungen an die Qualität von Pufferschichten sind denen der nichtsupraleitenden Schichten für Bauelemente vergleichbar.

Es ist vorstellbar, bestimmte Nachteile einer Pufferschicht in Kauf zu nehmen. Beispielsweise ist eine lokale Absenkung des Ordnungsparameters an der Grenzfläche zwischen Substrat und Hochtemperatursupraleiter in einem gewissen Umfang hinnehmbar, wenn die Schichtdicke des Supraleiters größer als beispielsweise 30nm ist.

Für Silizium wird beispielsweise Yttrium-stabilisiertes Zyrkon (YSZ) als Pufferschicht verwendet. Die Gitterfehlpassung von YSZ ist mit bis zu 6% relativ groß. Die chemische Kompatibilität ist nur eingeschränkt gegeben. Es wurde beobachtet, daß auf diese Weise an der Grenzfläche BaZrO₃ entsteht, welches als Fremdphase den Ordnungsparameter des YBa₂Cu₃0_{7-z} herabsetzt. Auch ist eine Diffusion von Zr auf Cu-Plätze mit der Folge eines reduzierten Ordnungsparameters im Supraleiter nachgewiesen worden.

Es wurde zwar eine Sprungtemperatur von 90K für YBa₂Cu₃O_{7-z} auf YSZ berichtet, doch zeigte die Untersuchung der Mikrostruktur, daß in c-Achsen-orientierten Dünnschichten Bereiche enthalten sind, welche fehlorientiert sind. Diese beeinträchtigen als schwache Kontakte beispielsweise die Stromtragfähigkeit.

Wird YBa₂Cu₃0_{7-z} direkt auf ein Saphir-Substrat aufgesputtert, kann an der Grenzfläche BaAl₂0₄ entstehen, was die Epitaxie des darauf aufwachsenden YBa₂Cu₃O_{7-z} stark beeinträchtigt (K. Dovidenko, S. Oktyabrsky and A. Ivanov, Mater. Sci. Eng. B 15, 25 (1992). Für Saphir-Substrate wird unter anderem CeO₂ als Puffer verwendet. Dabei kann der Fall eintreten, daß CeO₂ in zwei verschiedenen Orientierungen aufwächst (A. G. Zaitsev, R. Kutzner, R. Wördenweber, Appl. Phys. Lett. 67, 1 (1995)), so daß demzufolge sich die Epitaxie der auf CeO₂ abgeschiedenen YBa₂Cu₃O_{7-z}-Schichten deutlich verschlechtert.

### 3. Substratmaterialien

Der Einsatz eines Materials als Substrat für epitaktische Hochtemperatursupraleiter-Dünnfilme setzt die Herstellbarkeit als makroskopischer Einkristall voraus. Ferner ist zu folgenden spezifischen Anforderungen eine hinreichende Qualität an das in Frage kommende Substratmaterial erforderlich:
- chemische Kompatibilität mit dem aufzuwachsenden Dünnschichtmaterial
- Qualität der Oberfläche
- Reinheit des Materials
- Homogenität des Substrats
- thermodynamische Stabilität
- geringe Gitterfehlpassung zum Dünnschichtmaterial
- geringe Differenz in den thermischen Ausdehnungskoeffizienten

Diesbezüglich hat die Anforderung der chemischen Kompatibilität eine erhöhte Priorität, denn die meisten Substratmaterialien enthalten Ionen, die bei einer Interdiffusion in den Hochtemperatursupraleiter diesen schädigen. Eine Interdiffusion kann aber aufgrund einer relativ hohen Herstellungstemperatur der Hochtemperatursupraleiter nicht ausgeschlossen werden. So enthalten bekannte Substratmaterialien wie SrTi03, LaAlO₃ und MgO mit Ti⁺⁴, Al⁺³ und Mg⁺² Ionen, die im Supraleiter, insbesondere in der Verbindung YBa₂Cu₃O_{7-z}, die Sprungtemperatur erheblich reduzieren.

An einer epitaktischen Grenzfläche zwischen einem nichtsupraleitenden Material und einem Hochtemperatursupraleiter können neben Gitterverzerrungen und Gitterspannungen auch Fremdphasen und a-Achsen-orientierte Bereiche auftreten. Diese Abweichungen von der idealen Kristallstruktur der Hochtemperatursupraleiter sind oftmals nicht auf einen kleinen Bereich an der Grenzfläche beschränkt, sondern beeinflussen den Supraleiter in einem relativ groß ausgedehnten Bereich negativ.

Weiterhin kann es auf Pufferschichten und Substraten mit relativ großer Gitterfehlpassung bei c-Achsen-orientierten Supraleiterdünnschichten teilweise zu einer 45°-Rotation in der Substratebene kommen. Dies wurde beispielsweise in YBa₂Cu₃O_{7-z}-Dünnschichten auf MgO beobachtet und führt hier auf Grund der auftretenden Korngrenzen zu schlechteren Dünnschichteigenschaften.

Ferner stellen die Gitterfehlpassung und eine Differenz in den thermischen Ausdehnungskoeffizienten zwischen den Hochtemperatursupraleitern und einem anderen Material weitere Problemfelder dar.

Zusammenfassend lassen sich folgende Problemfelder erkennen, welche mehr oder weniger in jedem der drei diskutierten Anwendungsgebiete - supraleitende Bauelemente, Pufferschichten, Substrate - auftreten:

Alle bisher als Barriere in Josephson-Kontakten eingesetzten Materialien zeigen nur ein eingeschränktes Maß an chemischer Kompatibilität mit den Hochtemperatursupraleitern, wodurch die erzielten Eigenschaften der Josephson-Kontakte hinter den theoretisch möglichen Erwartungen zurückbleiben.

Ferner sind keine Puffermaterialien bekannt, auf denen eine ultradünne YBa₂Cu₃O₇₋₂-Schicht supraleitend ausbildbar ist, und wobei die Pufferschicht gleichzeitig eine atomare Stufen ausgleichende Wirkung zeigt.

Für die genannten drei Anwendungsgebiete werden häufig Materialien eingesetzt, die nur begrenzt chemisch kompatibel zu den Hochtemperatursupraleitern sind. Dieses wirkt sich nachteilig auf die darauf wachsenden supraleitenden Schichten aus, deren supraleitende Eigenschaften, insbesondere bei geringen Schichtdicken der supraleitenden Schicht, degradieren.

Es ist deshalb Aufgabe der Erfindung, eine Schichtenfolge bzw. ein Bauelement mit einer solchen Schichtenfolge zu schaffen, bei dem eine verbesserte chemische Kompatibilität an der Grenzfläche zwischen der supraleitenden und nichtsupraleitenden Schicht erreicht wird.
Es ist ferner Aufgabe der Erfindung eine Schichtenfolge bzw. ein Bauelement mit einer solchen Schichtenfolge zu schaffen, bei dem eine verbessert gitterfehlordnungsfreie Kristallstruktur an der Grenzfläche zwischen der supraleitenden und nichtsupraleitenden Schicht erreicht wird.

Insbesondere soll der Ordnungsparameter der supraleitenden Schicht durch Verbinden beider Schichten nicht nachteilig beeinträchtigt werden.

Die Aufgabe wird gelöst durch eine Schichtenfolge gemäß der Gesamtheit der Merkmale nach Anspruch 1. Weitere zweckmäßige oder vorteilhafte Ausführungsformen oder Varianten finden sich in den auf jeweils einen dieser Ansprüche rückbezogenen Unteransprüchen.

Die erfindungsgemäße Schichtenfolge ist zur Bildung einer Barriere in Josephson-Kontakten einsetzbar, ohne daß dabei der Ordnungsparameter der supraleitenden Elektroden an den Grenzflächen des Josephson-Kontakts reduziert ist.

Die erfindungsgemäße Schichtenfolge ist zudem geeignet, auf einer nichtsupraleitenden Schicht eine ultradünne Hochtemperatursupraleiter- bzw. REBa₂Cu₃O_{7-z}-Schicht ohne Reduktion des Ordnungsparameters zu bilden.

Zudem ist die erfindungsgemäße Schichtenfolge zur Bildung eines epitaktischen, supraleitenden Bauelements einsetzbar, vorteilhaft unter Vermeidung der Reduktion des Ordnungsparameters des Supraleiters in der Nähe der Grenzschicht zwischen diesem nichtsupraleitenden Material und der supraleitenden Schicht.

Die erfindungsgemäße Schichtenfolge ist zur Bildung einer Grenzfläche einsetzbar, die praktisch keine Verspannungen im Hochtemperatursupraleiter oder in der angrenzenden nichtsupraleitenden Schicht erzeugt.

Die erfindungsgemäße Schichtenfolge ist zudem geeignet, daß im Hochtemperatursupraleiter keine ausgedehnten Misfit-Versetzungen an der Grenzfläche zwischen den beiden Materialien auftreten.

Zudem ist die erfindungsgemäße Schichtenfolge zur Bildung eines epitaktischen, supraleitenden Bauelements einsetzbar, vorteilhaft unter Vermeidung einerseits eines a-Achsen-orientierten Wachstums in der hochtemperatursupraleitenden Schicht, andererseits beim c-Achsen-orientierten Wachstum der Hochtemperatursupraleiterdünnschichten durch Ausbildung von a-Achsen-orientierten Bereichen an der Grenzfläche in nukleierter Form.

Desweiteren ist die erfindungsgemäße Schichtenfolge dazu geeignet, daß bei Pufferschichten bzw. Substraten mit großer Gitterfehlpassung, wie z. B. MgO, keine Korngrenzen in der Supraleiterdünnschicht auftreten, die durch eine 45°-Rotation in der Schichtebene in Teilbereichen einer c-Achsen-orientierten Hochtemperatursupraleiterdünnschicht entstehen.

Schließlich kann die erfindungsgemäße Schichtenfolge eine mögliche Differenz der thermischen Ausdehnungskoeffizienten zwischen dem Hochtemperatursupraleiter und einem anderen Material und eine mögliche Gitterfehlpassung zwischen dem Hochtemperatursupraleiter und einem anderen Material ausgleichen.

Schließlich enthält die erfindungsgemäße Schichtenfolge eine nichtsupraleitende Schicht, welche eine verbesserte planarisierende Wirkung auf einer darauf aufwachsenden Hochtemperatursupraleiter- bzw. REBa₂Cu₃O_{7-z}-Schicht ausübt, ohne den Ordnungsparameter zu schädigen.

Im Sinne der Erfindung soll ein Ion oder eine Komponente dann chemisch kompatibel sein, wenn es/sie folgende Bedingung erfüllt: werden 10% eines Elements im Hochtemperatursupraleiter in der Schichtenfolge durch diese Ionensorte / Komponente ersetzt, darf eine Verringerung der Sprungtemperatur des supraleitenden Materials einen Wert von 5K nicht überschreiten.

Die Erfindung erstreckt sich auf das Bauelement im Sinne eines epitaktischen Multilagensystems, auf die Pufferschicht und auf das Substrat, falls epitaktische Dünnfilme aus Hochtemperatursupraleiter oder Materialien ähnlicher kristallografischer Struktur verwendet werden. Stellvertretend für die Klasse der Hochtemperatursupraleiter wird diesbezüglich das Material YBa₂Cu₃O_{7-z}, bzw. REBa₂Cu₃O_{7-z} mit RE= Y, Ca, La, Pr, Nd, Sm, Eu, Gd, Tb, Dy, Ho, Er, Tm, Yb, Lu genannt.

Es wurde erkannt, daß zur Lösung der Aufgabe die chemische Kompatibilität des Materials ein Hauptkriterium bildet. Dabei sollen oxidische nichtsupraleitende Materialien Verwendung finden, deren Atomsorten zum Supraleiter, insbesondere zu REBa₂Cu₃0_{7-z}, chemisch kompatibel sind. Diesbezüglich können als chemisch kompatible Elemente Cu, Ba, Sr, Ca, Cu, 0, sowie Y, La, Nd, Sm, Eu, Gd, Tb, Dy, Ho, Er, Tm, Yb oder Lu Beachtung finden.

Die Erfindung gemäß Patentanspruch 1 bis 8 ist im weiteren an Hand von Figuren und Ausführungsbeispielen näher erläutert. Es zeigt:
- Fig. 1:: Röntgendiffraktogram einer erfindungsgemäßen Schichtenfolge;
- Fig. 2:: Rocking-Kurve im Bereich der nichtsupraleitenden Schicht einer erfindungsgemäßen Schichtenfolge;
- Fig. 3:: Rutherford-Backscattering-Spektrum (RBS) im Bereich der nichtsupraleitenden Schicht einer erfindungsgemäßen Schichtenfolge;
- Fig. 4:: Random- (oben) und Channeling-(unten) Messung der RBS Analyse im Bereich der nichtsupraleitenden Schicht einer erfindungsgemäßen Schichtenfolge;
- Fig. 5a:: TEM-Aufnahme einer erfindungsgemäßen Schichtenfolge;
- Fig. 5b:: TEM-Aufnahme einer erfindungsgemäßen Schichtenfolge;
- Fig. 6a:: TEM-Aufnahme einer erfindungsgemäßen Schichtenfolge;
- Fig. 6b:: TEM-Aufnahme einer erfindungsgemäßen Schichtenfolge;

### Ausführungsbeispiel zu der Erfindung gemäß Patentanspruch 1-8

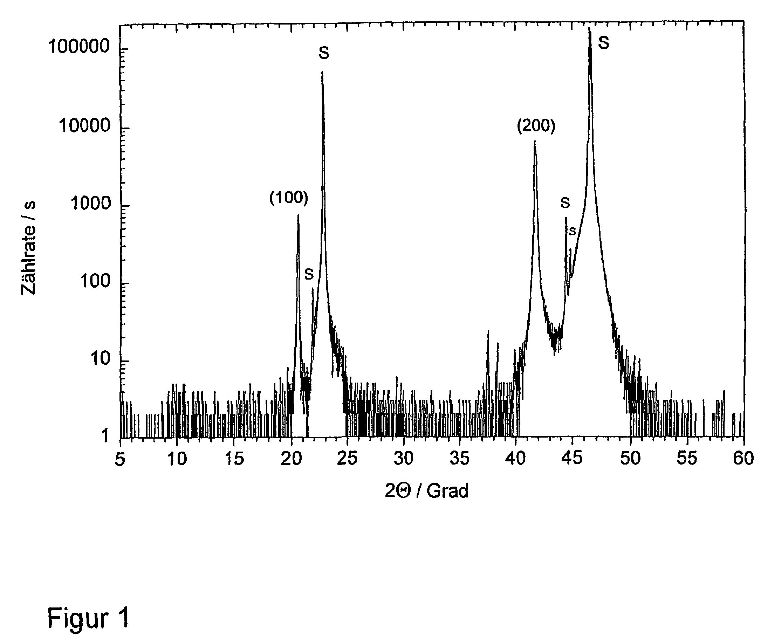

In der Figur 1 ist das Röntgendiffraktogram einer 120 nm dicken BaTbO₃-Schicht auf einem (100)-orientierten SrTiO₃-Substrat gezeigt. Es wurde bei der Messung die sogenannte Bragg-Bretano Geometrie verwendet. Neben den mit einem "S" gekennzeichneten Substratreflexen sind deutlich der (100)- und der (200)-Reflex des BaTbO₃ zu erkennen. Im gemessenen Winkelbereich von 2θ=5° bis 2θ=60° wurden keine weiteren Reflexe, die u.a. auf Fremdphasen hinweisen könnten, beobachtet.

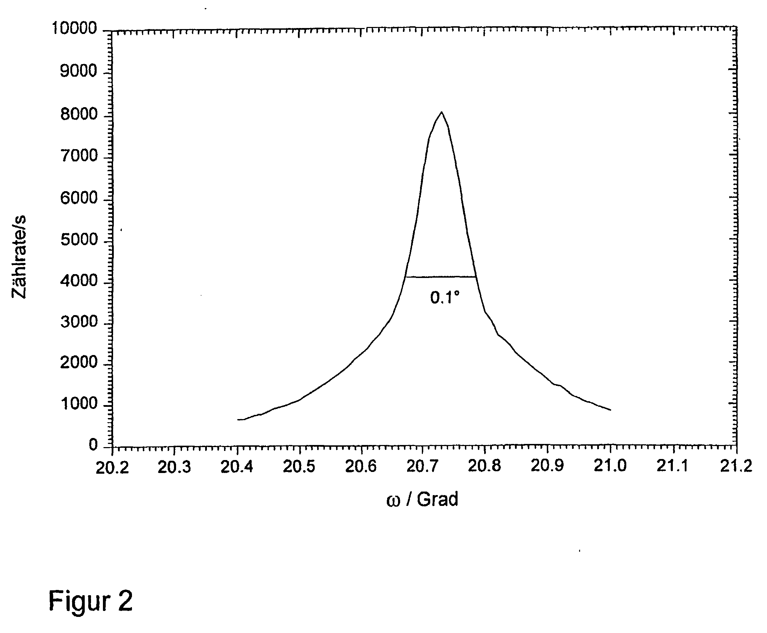

Die Halbwertsbreite der Rocking-Kurve in Figur 2, ein sogenannter ω-scan, beträgt nur 0,1°, gemessen am (200)-Reflex, was auf eine geringe Winkelverkippung der Netzebenen schließen läßt.

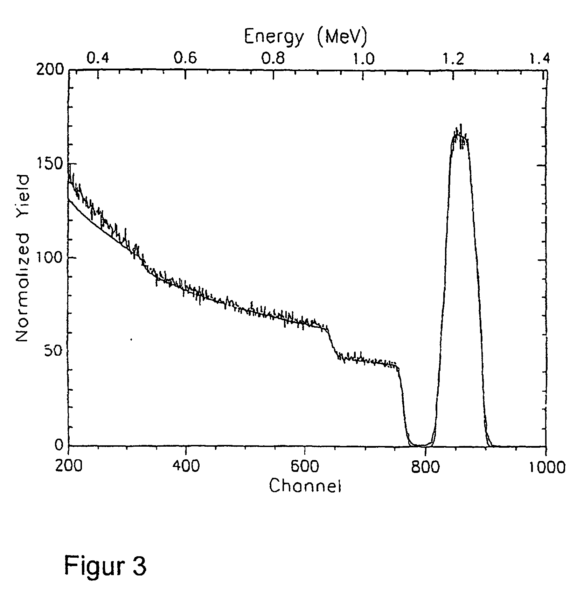

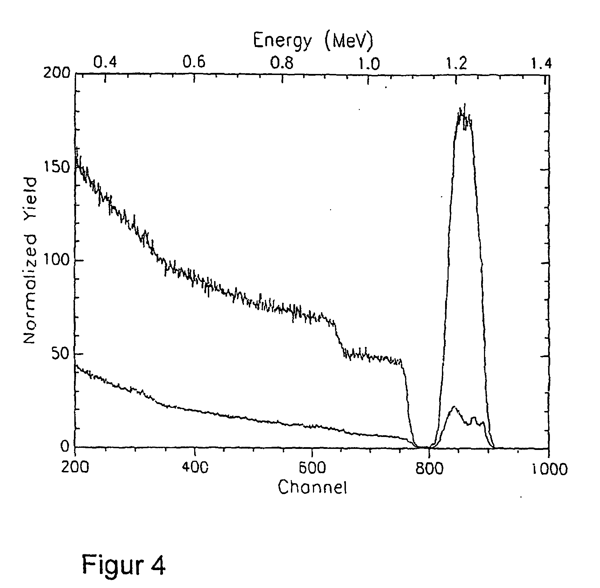

Das Ergebnis der RBS-Untersuchung ist in Figur 3 gezeigt. Aufgrund des Übereinanderliegens von Meßkurve und Simulation(durchgezogene Linie) konnte auf das richtige Kationenverhältnis geschlossen werden. Die Channeling-Messung, dargelegt in Figur 4, ergibt einen günstigen Minimum-Yield-Wert von nur 7%.

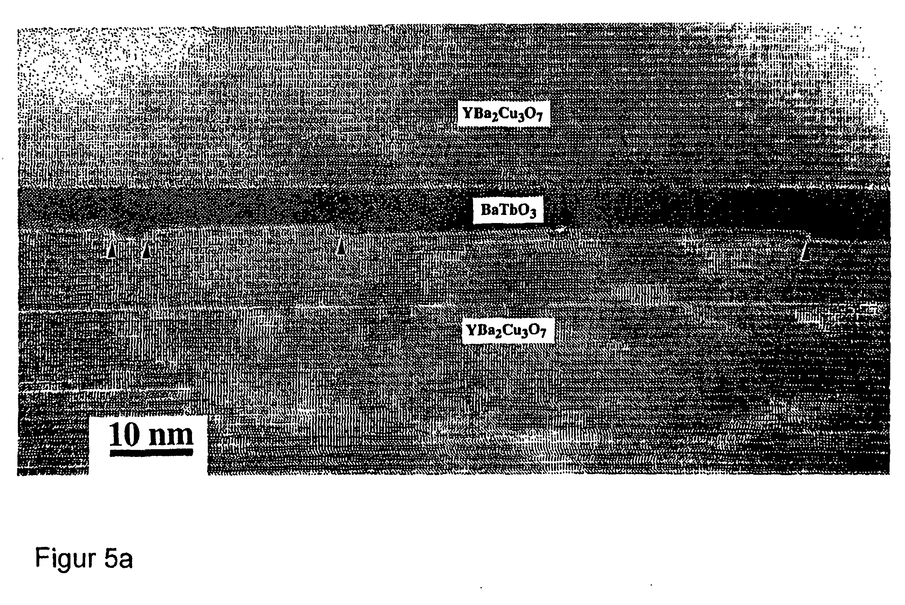

In der Figur 5a ist eine TEM-Aufnahme zur Verdeutlichung der Heterostruktur gezeigt. Zur Untersuchung mittels Transmissionselektronenmikroskopie (TEM) wurde eine solche erfindungsgemäße Heterostruktur-Dünnschichtenfolge auf einem SrTiO₃-Substrat hergestellt, bestehend aus folgenden Schichten:

| | |
|---|---|
| 1. Schicht | 35nm YBa₂Cu₃O_{7-z} |
| 2. Schicht | 12nm BaTb0₃ |
| 3. Schicht | 35nm YBa₂Cu₃O_{7-z} |

Bei den TEM-Untersuchungen an einer solchen erfindungsgemäßen Schichtenfolge ergaben sich folgende Feststellungen:

Es wurde ein epitaktisches Wachstum aller Schichten festgestellt, wobei das YBa₂Cu₃O_{7-z} vorteilhafterweise ausschließlich c-Achsen-orientiert und das BaTbO₃ nur [100]-orientiert gewachsen ist. Damit wurde eine heteroepitaktische Schichtenfolge von BaTbO₃ Mit YBa₂Cu₃O_{7-z} experimentell gezeigt. Die Grenzflächen waren frei von Fremdphasen oder fehlorientierten Bereichen, insbesondere unterblieb ein a-Achsen-Wachstum.

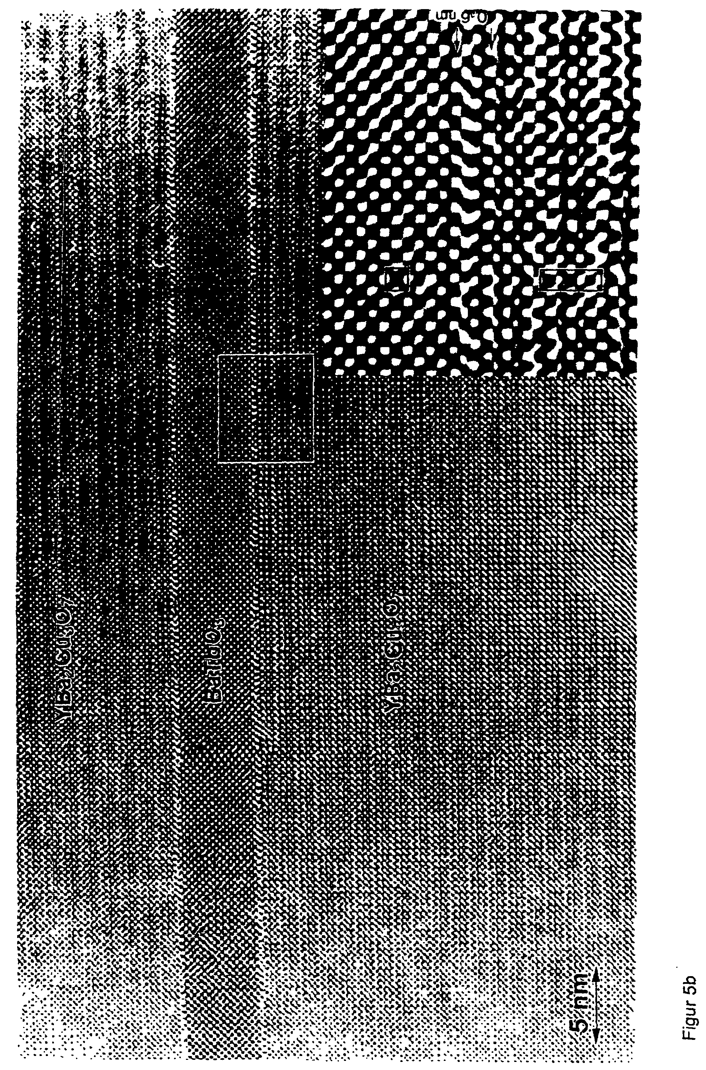

Typische Grenzflächen einer solchen Struktur sind in Figur 5b gezeigt. Ähnlich wie SrTiO₃ besitzt BaTbO₃ ebenfalls die Fähigkeit, Unregelmäßigkeiten einer YBa₂Cu₃O_{7-z}-Oberfläche auszugleichen. D. h. wird BaTbO₃ auf eine YBa₂Cu₃O_{7-z}-Oberfläche, welche Stufen enthält, aufgewachsen, überdeckt es diese und bildet nach wenigen nm Dicke vorteilhaft eine glatte [100]-Oberfläche, auf welcher das YBa₂Cu₃0_{7-z} c-Achsen-orientiert aufwächst. Es wird diesbezüglich angenommen, daß niedrig indizierte Flächen der BaTbO₃-Gitterstruktur eine geringe Oberflächenenergie aufweisen und daher bevorzugte Grenzflächen darstellen.

Somit hat insbesondere BaTbO₃ eine planarisierende Wirkung in Bezug auf rauhe epitaktische Unterlagen und bietet dem darauf zu deponierendem YBa₂Cu₃O_{7-z} eine vorteilhaft glatte Oberfläche.

Als Material für die nichtsupraleitende Schicht in der Schichtenfolge wird insbesondere die sehr geeignete, perovskitische Verbindung Ba₁₋ₓSrₓTbO₃ vorgeschlagen, wobei der Wert x im Bereich von 0 bis 1 gewählt werden kann. Die rhomboedrische Kristallstruktur dieser Verbindung kann auf Grund einer geringen Abweichung von einer kubischen Struktur als pseudo-kubische Perovskit-Struktur aufgefaßt werden. Zwar ist dieses Material bekannt (E. Paletta, R. Hoppe, *Naturwissenschaften 53,* *611 (1966)* und A. J. Jacobson, B.C. Tofield, B.E.F. Fender, Acta, Cryst. *B28, 956 (1972))*, bisher ist in der Literatur allerdings nur über die Herstellung von Pulverproben berichtet worden. Dünnschichten und makroskopische Einkristalle sind jedoch nicht bekannt. Diese Verbindung weist vorteilhafterweise thermodynamisch eine vergleichsweise hohe Stabilität auf.

Die chemische Kompatibilität mit den Hochtemperatursupraleitern ist unter dem Gesichtpunkt der in der Verbindung enthaltenen Elemente gegeben, da einerseits Ba und 0 in den REBa₂Cu₃O_{7-z} -Verbindungen enthalten ist, andererseits Tb bis zu 40% zu den REBa₂Cu₃O_{7-z}-Verbindungen dotiert werden kann, ohne das die Sprungtemperatur merklich (weniger als 1K) abfällt. Schließlich kann Sr zu den REBa₂Cu₃O_{7-z} dotiert werden, ohne daß die Sprungtemperatur merklich reduziert wird; sogar wenn 60% der Ba-Atome durch Sr-Atome ersetzt werden, verringert sich das T_{c} nur um 8K.

Innerhalb der Reihe der Seltenen Erden (RE) nimmt Tb eine Ausnahmestellung ein, da es in oktaedrischer Sauerstoffumgebung im Perovskiten auch als vierwertiges, relativ kleines Ion eingebaut werden kann, ohne wie im Falle des Pr oder Ce auch paarbrechende Eigenschaften bzw. dotierende Wirkung zu besitzen, welche die Supraleitung nachteilig mindern.

Es wurden epitaktische BaTbO₃-Dünnschichten auf SrTiO₃und Mg0-Substraten durch RF-Sputtern in reinem Sauerstoff (U. Poppe et al., Solid State *Comm. 66, 661 (1988))* bei einem Druck im Bereich 2-4 mbar hergestellt, deren Struktur mittels Röntgendiffraktometrie, RBS/Channeling mit He-Ionen und Transmissionselektronenmikroskopie untersucht wurden.

Außerdem wurden folgende für Anwendungen günstige Eigenschaften der erfindungsgemäßen Schichtenfolge und des erfindungsgemäßen Bauelements beobachtet: Gitterspannungen werden lokal an der Grenzfläche ohne Einführung von ausgedehnten Misfit-Versetzungen abgebaut. Zudem werden Fremdphasen und fehlorientierte Bereiche an der Grenzfläche nicht beobachtet. Für YBa₂Cu₃O_{7-z} wurde kein a-Achsen-Wachstum beobachtet.

Aus der Literatur ist bekannt, daß polykristalline Massivproben aus BaTbO₃ elektrisch isolierend sind. Die erfindungsgemäß hergestellten epitaktischen BaTbO₃-Schichten erwiesen sich ebenfalls als isolierend.

Aufgrund der Vielzahl von Materialien, die mit BaTbO₃ unter dem Gesichtspunkt der chemischen Kompatibilität zu den Hochtemperatursupraleitern eng verwandt sind und der Vielzahl von Materialien der Hochtemperatursupraleiter bzw. Materialien mit ähnlicher kristallografischer Struktur, ertreckt sich die Erfindung auch auf folgende Materialien:

| | | |
|---|---|---|
| (i) | Ba₁₋ₓSrₓTbO₃ | mit 0 ≤ x ≤ 1; |
| | | |
| (ii) | R_{1-y}N_{y}TbO₃ | mit 0 ≤ y < 1; mit R = La, Nd, Eu, Sm; mit N = Ba, Sr; |
| | | |
| (iii) | R_{2-y}N_{y}TbO₄ | mit 0 ≤ y ≤ 2; mit R = La, Nd, Eu, Sm; mit N = Ba, Sr; |

Als mit den Hochtemperatursupraleitern chemisch kompatible Materialien sollen insbesondere die genannten Materialien und Materialklassen mit perovskitähnlicher Struktur verstanden werden.

Mit "Hochtemperatursupraleiter und Materialien ähnlicher kristallografischer Struktur" sind Substanzen mit mindestens drei verschiedenen Elementen in der Einheitszelle gemeint, von denen zwei Sauerstoff und Kupfer sind. Ferner soll in der Einheitszelle mindestens eine CUO₂-Ebene - das Charakteristikum der Hochtemperatursupraleiter - vorhanden sein.

Das Schutzbegehren soll sich auch auf REBa₂Cu₃O_{7-z} - Verbindungen erstrecken, mit RE=Y, Ca, La, Pr, Nd, Sm, Eu, Gd, Tb, Dy, Ho, Er, Tm, Yb, Lu.

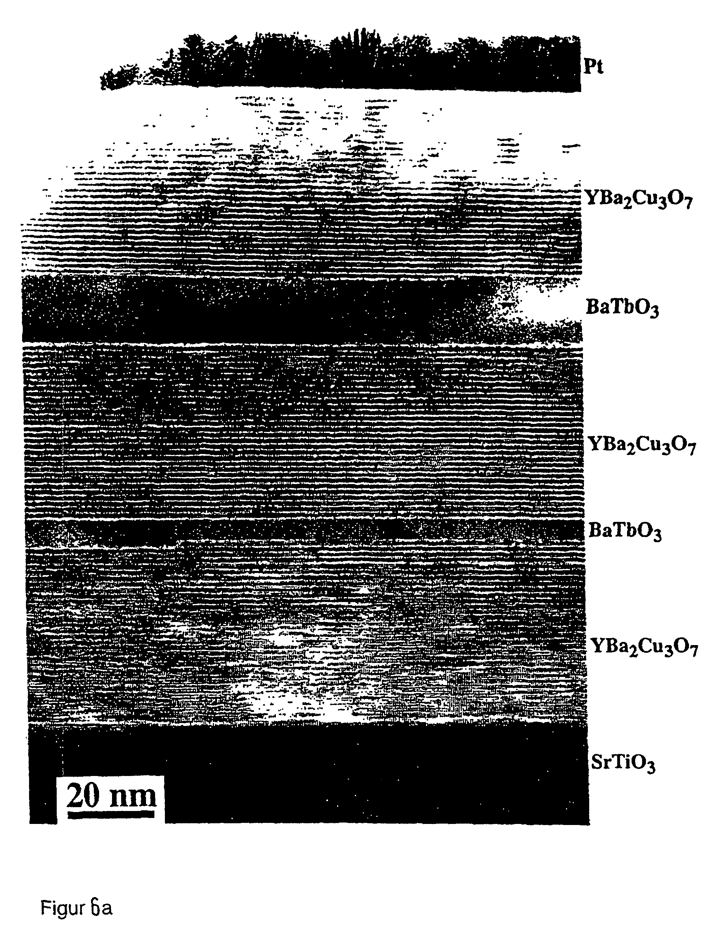

In der Figur 6a ist eine TEM-Aufnahme der erfindungsgemäßen Heterostruktur gezeigt. Zur Untersuchung mittels Transmissionselektronenmikroskopie (TEM) wurde eine solche erfindungsgemäße Heterostruktur-Dünnschichtenfolge auf einem SrTi03-Substrat hergestellt, bestehend aus folgenden Schichten:

| | |
|---|---|
| 1. Schicht | 35nm YBa₂Cu₃0_{7-z} |
| 2. Schicht | 4-5nm BaTbO₃ |
| 3. Schicht | 35nm YBa₂Cu₃0_{7-z} |
| 4. Schicht | 12nm BaTbO₃ |
| 5. Schicht | 35nm YBa₂Cu₃O_{7-z} |

Bei den TEM-Untersuchungen an einer solchen erfindungsgemäßen Schichtenfolge ergaben sich folgende Feststellungen:

Es wurde ein epitaktisches Wachstum aller Schichten festgestellt, wobei das YBa₂Cu₃O_{7-z} vorteilhafterweise ausschließlich cAchsen-orientiert und das BaTb03 nur [100]-orientiert gewachsen ist. Damit wurde eine heteroepitaktische Schichtenfolge von BaTbO₃ mit YBa₂Cu₃O_{7-z} experimentell gezeigt.

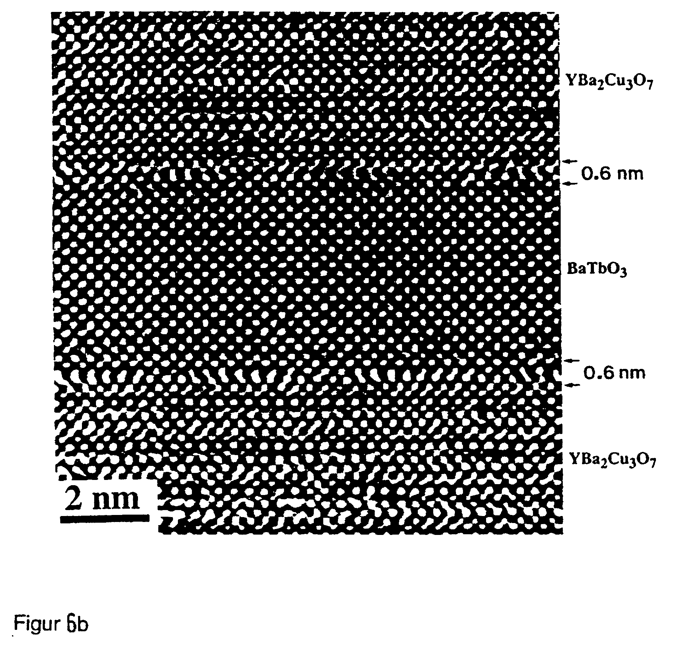

An den Grenzflächen wurden keine Fremdphasen und keine fehlorientierten Bereiche, insbesondere kein a-Achsen-Wachstum und keine um 45° in der Schichtebene verdrehten Bereiche beobachtet. Aufgrund der mit 10% großen Gitterfehlpassung von BaTbO₃ zu YBa₂Cu₃O_{7-z} war zu vermuten, daß, wie bei MgO mit ähnlich großer Gitterfehlpassung, auch Großwinkel-Korngrenzen, entstanden durch um 45° in der Schichtebene verdrehte Bereiche, und starke Verzerrungen des Gitters in der Nähe eines sehr dichten Vernetzungswerkes auftreten können. Dieses wurde jedoch nicht beobachtet, wie im Ergebnis aus der Figur 6b entnehmbar ist.

Zwischen der - jeweiligen - BaTbO₃- und YBa₂Cu₃O_{7-z}-Schicht befindet sich eine nahezu atomar scharfe 6Å dicke Zwischenschicht mit inkommensurabler Struktur, in welcher die Atomabstände variabel sind und somit durch Spannungen die Gitterfehlpassung nahezu lokal an der Grenzfläche abgebaut werden kann (Figur 6b).

Vermutlich besteht diese Zwischenschicht aus einer sauerstoffdefizienten Doppellage, in welcher Kationen variabler Valenz wie Tb^{+3/+4} und Cu^{+1/+2/+3} beteiligt sind. Es wurde zudem erkannt, daß weder bei der erfindungsgemäßen Schichtenfolge in den BaTbO₃- noch in den YBa₂Cu₃O_{7-z}-Schichten in einem Abstand von weniger als 1 nm von der Grenzfläche entfernt merkliche Gitterverzerrungen auftraten (Figur 6b).

Durch das Einfügen der Zwischenschicht und Variation der atomaren Abstände in dieser, werden die Gitterspannungen, die durch die Kombination von YBa₂Cu₃O_{7-z} mit BaTbO₃ entstehen, abgebaut. Folglich ist es nicht erforderlich, den Sauerstoffgehalt in der Nähe der Grenzfläche zum Abbauen von Gitterspannungen zu reduzieren.

Als Material für die nichtsupraleitende Schicht in der Schichtenfolge wird insbesondere die sehr geeignete, perovskitische Verbindung Ba₁₋ₓSrₓTbO₃ vorgeschlagen, wobei der Wert x im Bereich von 0 bis 1 gewählt werden kann. Die rhomboedrische Kristallstruktur dieser Verbindung kann auf Grund einer geringen Abweichung von einer kubischen Struktur als pseudo-kubische Perovskit-Struktur aufgefaßt werden. Zwar ist dieses Material bekannt (E. Paletta, R. Hoppe, *Naturwissenschaften* 53, 611 (1966) und A. J. Jacobson, B.C. Tofield, B.E.F. Fender, Acta, Cryst. B28, 956 (1972)), bisher ist in der Literatur allerdings nur über die Herstellung von Pulverproben berichtet worden. Dünnschichten und makroskopische Einkristalle sind jedoch nicht bekannt. Diese Verbindung weist vorteilhafterweise thermodynamisch eine vergleichsweise hohe Stabilität auf.

Mit der erfindungsgemäßen Schichtenfolge ist gezeigt, daß trotz der großen Gitterfehlpassung von 10%, die Mikrostruktur von YBa₂Cu₃O_{7-z}-Dünnschichten, welche auf BaTbO₃ aufwachsen, nicht durch Gitterverzerrungen, ausgedehnte Misfit-Versetzungen, Fremdphasenwachstum, a-Achsen-Wachstum oder Rißbildung gestört wird. Dieses Ergebnis beruht wesentlich auf den Eigenschaften des BaTbO₃, als Grenzfläche zum Hochtemperatursupraleiter die oben beschriebene Zwischenschicht zu bilden, da diese Zwischenschicht wesentlich zum Abbau der Gitterspannungen beiträgt und auf diese Weise Gitterverzerrungen im Supraleiter verhindert.

Es wird angenommen, daß hinsichtlich der Beschaffenheit der Zwischenlage anzunehmen ist, daß Tb-Ionen und/oder Cu-Ionen beteiligt sind und mittels ihrer variablen Valenz den Sauerstoffgehalt und damit die Gitterabstände in der Zwischenschicht variieren. Deshalb kommen auch andere Perovskite, die Ionen variabler Valenz enthalten, zur Ausbildung einer solchen Zwischenschicht als Grenzfläche in Betracht.

Als dem Material BaTbO₃ sehr verwandt sind diesbezüglich insbesondere BaPrO₃ sowie BaCeO₃ zu nennen, wobei Pr und Ce wie Tb ebenfalls drei- oder vierwertig sind. Eine leichte Einschränkung des Materials BaCeO₃ beruht darauf, daß das Ce⁺⁴ wesentlich stabiler als das Ce⁺³ ist und daher die Variabilität der Valenz des Ce-Ions stärker eingeschränkt ist, als es für das Pr und Tb der Fall ist.

Unter der Annahme, daß Tb- und Cu-Ionen variabler Valenz an der Zwischenschicht beteiligt sind, kommen deshalb auch andere perovskitähnliche Verbindungen, die Cu-, Tb-, Pr- oder Ce-Ionen enthalten, in Verbindung mit Materialien, die mindestens eine Cu0₂-Ebene in der Einheitszelle enthalten, in Betracht, die oben beschriebene Zwischenschicht als Grenzflächenschicht auszubilden.

Hinsichtlich der chemischen Kompatibilität sind BaCeO₃ und BaPrO₃ zwar weniger geeignete Kandidaten für Barrierenmaterialien in Josephson-Kontakten, da Pr- und Ce-Ionen die Sprungtemperatur der Hochtemperatursupraleiter senken. Dafür sind diese Materialien beispielsweise zum Einsatz zur Bildung einer Pufferschicht geeignet. Aufgrund der oben beschriebenen Struktur der Zwischenschicht sind die chemischen Bindungskräfte in dieser Schicht im Vergleich zu denen jenseits der Grenzfläche schwächer. Auf diese Weise ist es möglich, Gitterspannungen jenseits der Grenzfläche auch bei tieferen Temperaturen abzubauen.

Die genannten Ergebnisse lassen weiter den Schluß zu, daß BaTbO₃ nicht nur in ein epitaktisches Mehrlagensystem integriert werden kann, sondern sogar als Barrierenmaterial in Josephson-Kontakten verwendet werden kann.

Bisher ist noch kein weiteres Material als BaTbPO₃ mit Perovskitstruktur bekannt, das in einer Heterostruktur die Mikrostruktur des YBa₂Cu₃O_{7-z} selbst an der Grenzfläche nicht durch Gitterverzerrungen, ausgedehnte Misfit-Versetzungen, Fremdphasenwachstum, lokales a-Achsen-Wachstum, Rißbildung oder Großwinkel-Korngrenzen, entstanden durch um 45° in der Schichtebene verdrehte Schichtbereiche, stört.

Lediglich ein auf weniger als 1 nm Dicke beschränkter Bereich mit leichter Gitterverzerrung ist im Supraleiter direkt über der oben beschriebenen Zwischenschicht beobachtet worden.

Zum Einsatz als Puffermaterial auf Substraten, insbesondere in Verbindung mit Hochtemperatur-Dünnschichten ist es daher in besonderem Maße geeignet. Folgende Gesichtspunkte kommen hierfür zum Tragen: BaTbO₃ kann als Pufferschicht auf chemisch nichtkompatiblen Substraten eingesetzt werden, um als Diffusionsbarriere gegen, für die Supraleitung schädlichen Substraktionen, zu wirken. Ferner ist eine Verwendung als Pufferschicht auf zu den Hochtemperatursupraleiter gitterfehlgepaßten Substraten, wie beispielsweise MgO oder Al₂O₃, möglich, um unerwünschte Verspannungen im aufzuwachsenden Dünnfilm zu vermeiden. Desweiteren ist ein Einsatz als Pufferschicht auf Substraten, wie zum Beispiel Silizium, deren thermische Ausdehnungskoeffizienten stark von denen des aufzuwachsenden Dünnfilmes abweichen, möglich. Solche Substrate führen ohne Pufferschicht normalerweise zur Rißbildung im Dünnfilm.

Ein aus BaTb0₃/YBa₂Cu₃0_{7-z} bestehendes epitaktisches Heterosystem kann auch dazu eingesetzt werden, zwei beliebige Materialien, die nicht direkt epitaktisch oder nur mit starken Störungen der Mikrostruktur verbindbar sind, durch Einfügen einer Pufferschicht epitaktisch miteinander zu verbinden. Aufgrund der einfachen, chemischen Zusammensetzung und der hohen thermodynamischen Stabilität der Verbindung ist die Möglichkeit der Herstellung makroskopischer Substrat-Einkristalle gegeben.

Außerdem wurden folgende für Anwendungen günstige Eigenschaften der erfindungsgemäßen Schichtenfolge und des erfindungsgemäßen Bauelements beobachtet:

In bezug auf eine rauhe Unterlage hat BaTbO₃ eine planarisierende Wirkung. BaTbO₃ enthält vorteilhafterweise nur Elemente, die zum Hochtemperatursupraleiter chemisch kompatibel sind. Aus der Literatur ist zunächst nur bekannt, daß polykristalline Massivproben aus BaTbO₃ elektrisch isolierend sind. Die erfindungsgemäß epitaktische BaTbO₃-Dünnschichtenfolge erwies sich ebenfalls als isolierend.

## Patentansprüche

1. Schichtenfolge, enthaltend wenigstens eine Schicht auf der Basis eines hochtemperatursupraleitenden Materials, mit wenigstens einer CuO₂-Ebene aufweisenden Einheitszelle, wobei die Schicht direkt oder über eine Zwischenschicht mit einer nicht supraleitenden Schicht verbunden ist,
**gekennzeichnet durch**
eines der Materialien aus einer der Klassen (i) bis (iii) mit
| | | |
|---|---|---|
| (i) | Ba₁₋ₓSrₓTbO₃ | mit 0 ≤ x ≤ 1; |
| | | |
| (ii) | R_{1-y}N_{y}TbO₃ | mit 0 ≤ y < 1; |
| | | mit R = La, Nd, Eu, Sm; |
| | | mit N = Ba, Sr; |
| | | |
| (iii) | R_{2-y}N_{y}TbO₄ | mit 0 ≤ y ≤ 2; |
| | | mit R = La, Nd, Eu, Sm; |
| | | mit N = Ba, Sr; |
als Material für die nicht supraleitende Schicht.

2. Schichtenfolge nach Anspruch 1, **dadurch gekennzeichnet, daß** die nicht-supraleitende Schicht eine Pufferschicht zwischen der hochtemperatursupraleitenden Schicht und der Oberfläche eines Substrats bildet.

3. Schichtenfolge nach Anspruch 1, **dadurch gekennzeichnet, daß** die nicht-supraleitende Schicht als Substrat ausgebildet ist.

4. Verwendung mehrerer Schichtenfolgen nach einem der vorhergehenden Ansprüche zur Bildung eines Multilagensystems.

5. Verwendung wenigstens einer Schichtenfolge nach einem der Ansprüche 1 bis 3 zur Bildung eines kryogenen Bauelements.

6. Verwendung wenigstens eines Multilagensystems nach Anspruch 4 zur Bildung eines kryogenen Bauelements.

7. Verwendung eines Josephsonkontakts als kryogenes Bauelement nach Anspruch 5 oder 6.

8. Verwendung eines kryogenen Bauelements nach Anspruch 5 oder 6, zum Ausgleichen einer Gitterfehlpassung zwischen einem Hochtemperatursupraleiter und einem anderen beliebigen Material.

## Claims

1. Series of layers including at least one layer based on a high-temperature superconductor material with a unit cell having at least one CuO₂ plane, whereby the layer is connected directly, or via an intermediate layer, to a non-superconducting layer,
**characterised in that** one of the materials comes from one of the classes (i) to (iii) being
| | | |
|---|---|---|
| (i) | Ba₁₋ₓSrₓTbO₃ | where 0 ≤ x ≤ 1; |
| (ii) | R_{1-y}N_{y}TbO₃ | where 0 ≤ y < 1; |
| | | where R = La, Nd, Eu, Sm; |
| | | where N = Ba, Sr; |
| (iii) | R_{2-y}N_{y}TbO₄ | where 0 ≤ y < 2; |
| | | where R = La, Nd, Eu, Sm; |
| | | where N = Ba, Sr; |
as the material for the non-superconducting layer.

2. Series of layers according to Claim 1, **characterised in that** the non-superconducting layer comprises a buffer layer between the high-temperature superconducting layer and the surface of a substrate.

3. Series of layers according to Claim 1, **characterised in that** the non-superconducting layer is formed as a substrate.

4. Use of a plurality of series of layers according to one of the previous claims for forming a multi-layer system.

5. Use of at least one series of layers according to one of the claims 1 to 3 for forming a cryogenic component.

6. Use of at least one multi-layer system according to Claim 4 for forming a cryogenic component.

7. Use of a Josephson junction as a cryogenic component according to Claim 5 or 6.

8. Use of a cryogenic component according to Claim 5 or 6 for compensating for a lattice misfit between a high-temperature superconductor and an arbitrary other material.

## Revendications

1. Série de couches, contenant au moins une couche à base d'un matériau supraconducteur à haute température, avec au moins une maille présentant un plan CuO₂, où la couche est reliée directement ou par une couche intermédiaire, à une couche non supraconductrice, **caractérisée par** un matériau choisi parmi l'une des classe (i) à (iii), avec
| | | |
|---|---|---|
| (i) | Ba₁₋ₓSrₓTbO₃ | avec 0 ≤ x ≤ 1 ; |
| (ii) | R_{1-y}N_{y}TbO₃ | avec 0 ≤ y < 1 ; |
| | | avec R = La, Nd, Eu, Sm ; |
| | | avec N = Ba, Sr ; |
| (iii) | R_{2-y}N_{y}TbO₄ | avec 0 ≤ y ≤ 2 ; |
| | | avec R = La, Nd, Eu, Sm ; |
| | | avec N = Ba, Sr ; |
comme matériau de la couche non supraconductrice.

2. Série de couches selon la revendication 1, **caractérisée en ce que** la couche non supraconductrice forme une couche tampon entre la couche supraconductrice à haute température et la surface d'un substrat.

3. Série de couches selon la revendication 1, **caractérisée en ce que** la couche non supraconductrice est formée comme substrat.

4. Utilisation de plusieurs séries de couches selon l'une quelconque des revendications précédentes, pour former un système multicouche.

5. Utilisation d'au moins une série de couches selon l'une quelconque des revendications 1 à 3, pour former un élément structural cryogénique.

6. Utilisation d'au moins un système multicouche selon la revendication 4, pour former un élément structural cryogénique.

7. Utilisation d'un contact de Josephson comme élément structural cryogénique selon la revendication 5 ou 6.

8. Utilisation d'un élément structural cryogénique selon la revendication 5 ou 6, pour compenser un défaut de réseau entre un supraconducteur à haute température et un autre matériau quelconque.
